# EUROPEAN PATENT SPECIFICATION

(11) **EP 1 818 831 B1**
(45) Date of publication and mention of the grant of the patent: **12.11.2008**
(21) Application number: 07108400.8
(22) Date of filing: 27.06.2003
(51) Int. Cl.: G06F 12/08, G11C 16/16

(54) **Data transfer method and system**
Verfahren und System zur Datenübertragung
Procédé et système de transfert de données

(43) Date of publication of application: 15.08.2007
(62) Divisional of application: 03736289.4
(73) Proprietor: Fujitsu Ltd., Kawasaki-shi, Kanagawa 211-8588 (JP)
(72) Inventor: Fujioka, Shinya, Kawasaki-shi, Kagawa 211-8588 (JP); Sato, Kotoku, Kawasaki-shi, Kagawa 211-8588 (JP); Ikeda, Hitoshi, Kawasaki-shi, Kagawa 211-8588 (JP); Okuyama, Yoshiaki, Kawasaki-shi, Kagawa 211-8588 (JP); Ohno, Jun, Kawasaki-shi, Kagawa 211-8588 (JP)
(74) Representative: Seeger, Wolfgang

(56) References cited:
- EP-A- 0 760 513
- US-A1- 2002 064 079

## Description

### TECHNICAL FIELD

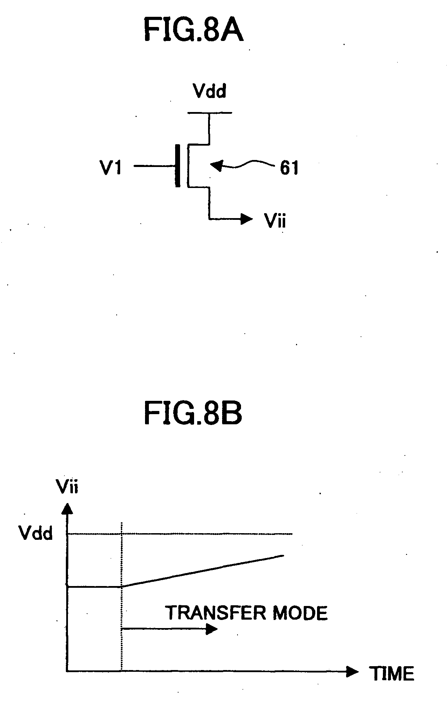

The present invention relates to reducing current consumption in a memory device by setting the memory device in a transfer mode wherein the operation voltage is reduced to a stepped-down potential and refresh is suspended as set out in context with present fig.8. Due to the suspension of the refresh operation, current flow is reduced which leads to a rise in the stepped-down potential. This results in the problem that, upon resuming normal mode, the stepped-down voltage is too high and the correct start of normal operation may fail.

US 2002/00640079 A1 discloses a memory device with reduced current consumption by stepping down the operation voltage and suspending the refresh operation.

EP 0 760 513 A2 discloses stabilization of a stepped-down potential (fig.6: VINT) by using a current consuming transistor (9). This current consuming transistor, however, is permanently driven.

### DISCLOSURE OF THE INVENTION

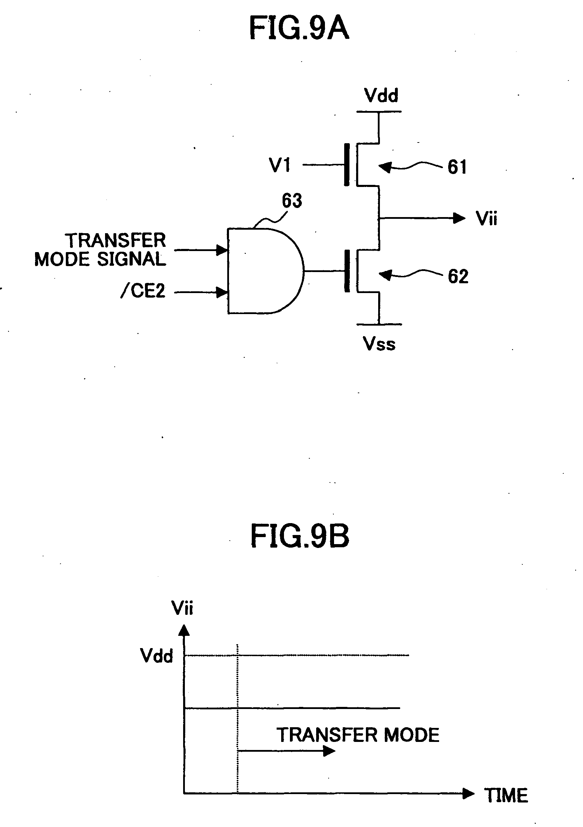

The invention is explained in context with present fig.9 and defined by claim 1.

### BRIEF DESCRIPTION OF DRAWINGS

Fig. 1 is a block diagram showing the configuration of an information processing system to which the present invention is applied.
Fig. 2 is a block diagram showing the configuration of a pseudo SRAM.
Fig. 3 is a drawing for explaining relationships between a memory core, write register, and data register of the pseudo SRAM.
Fig. 4 is a flowchart showing a data transfer operation according to the present invention.
Fig. 5 is a flowchart showing a detail of transfer process.
Fig. 6 is a flowchart showing another embodiment of the transfer process according to the present invention.
Fig. 7 is a drawing showing an example of the configuration of a refresh request signal generating circuit of the pseudo SRAM.
Fig. 8A is a diagram showing a typical configuration of a stepped-down potential generating circuit that generates an internal stepped-down potential in the pseudo SRAM.
Fig. 8B is a diagram showing a change in the stepped-down potential after the pseudo SRAM enters into a transfer mode.
Fig. 9A is a diagram showing a configuration of the stepped-down potential generating circuit according to the present invention.
Fig. 9B is a diagram showing a change in the stepped-down potential after the pseudo SRAM enters into the transfer mode.

### BEST MODE FOR CARRYING OUT THE INVENTION

In the following, embodiments of the present invention will be described with reference to the accompanying drawings.

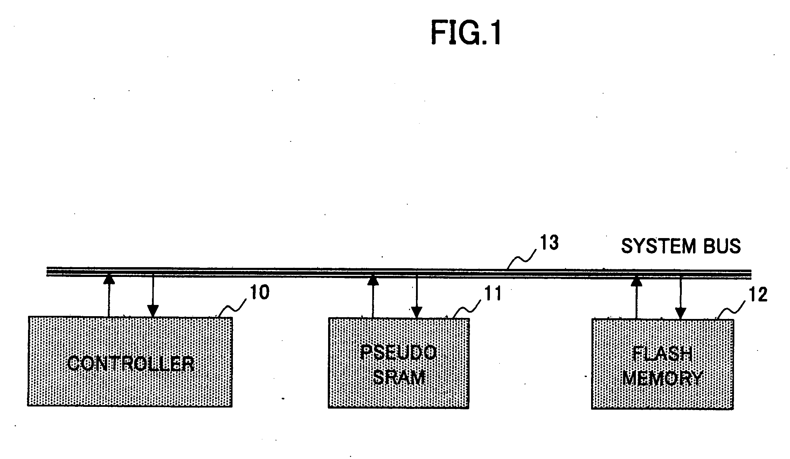

Fig. 1 is a block diagram showing the configuration of an information processing system according to the present invention.

The information processing system of Fig. 1 is a memory system used in a mobile phone, for example, and includes a controller 10, a pseudo SRAM 11, a flash memory 12, and a system bus 13. The flash memory 12 is used to store therein programs to be executed and data to be processed by the controller 10. The pseudo SRAM 11 is used as a work memory area that is used at the time of moving picture processing or the like by the controller 10. Here, a memory serving as the work memory area suffices if it is a large size RAM, and is not limited to the pseudo SRAM. For example, a DRAM (Dynamic Random Access Memory), SDRAM (Synchronous Dynamic Random Access Memory), FRAM (Ferroelectric Random Access Memory), or the like may accomplish the same function in place of the pseudo SRAM 11 shown in Fig. 1.

The information processing system shown in Fig. 1 does not use an SRAM that was used in the related-art system for the purpose of storing data of relatively small size such as cache data. In the present invention, the function of such SRAM is taken over by the flash memory 12.

In the configuration in which the flash memory 12 stores cache data, a problem arises in that the write speed of the flash memory 12 is slow when transferring data from the controller 10 to the flash memory 12. Until the writing to the flash memory 12 is completed, the controller 10 needs to keep the contents of the internal cache, thus incapable of moving on to a next operation for a long time.

In the present invention, an internal register of the pseudo SRAM 11 is utilized as a place where the controller 10 stores transfer data in addition to the cache. First, the transfer data is stored in the internal register of the pseudo SRAM 11. Then, the data is transferred from the internal register of the pseudo SRAM 11 to the flash memory 12. A transfer status indicative of whether the transfer was successfully completed is checked so as to ensure reliable data transfer.

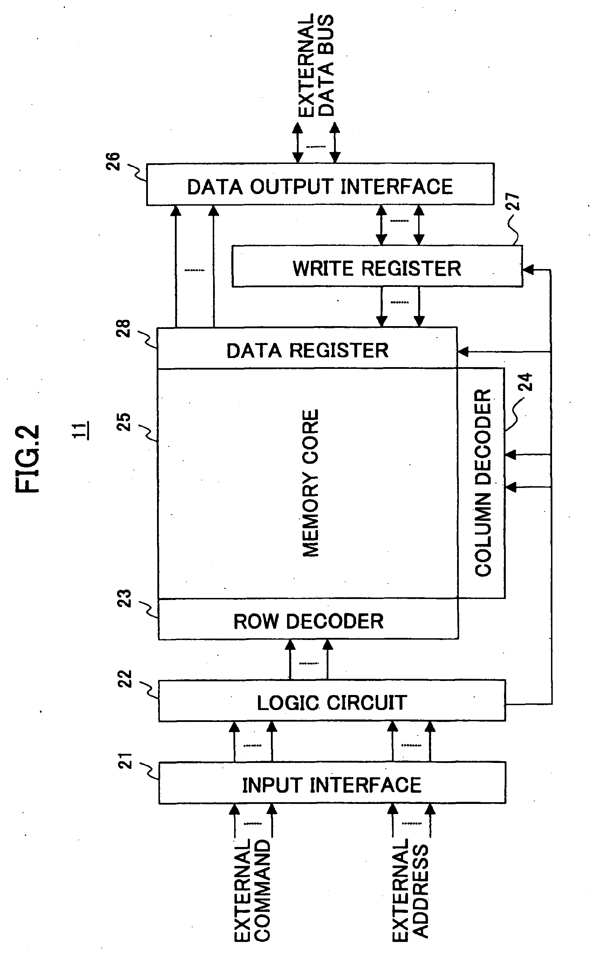

Fig. 2 is a block diagram showing the configuration of the pseudo SRAM 11.

The pseudo SRAM 11 includes an input interface 21, a logic circuit 22, a row decoder 23, a column decoder 24, a memory core 25, a data input/output interface 26, a write register 27, and a data register 28.

The input interface 21 receives a command signal and an address signal from an exterior, and supplies them to the logic circuit 22. The logic circuit 22 decodes the received command, and controls each part of the pseudo SRAM 11 according to the decoded results. The logic circuit 22 supplies a row address of the received address signal to the row decoder 23, and supplies a column address to the column decoder 24.

The row decoder 23 decodes the row address, and activates a word line corresponding to the word indicted by the decoded address. Data of the memory cells connected to the selectively activated word line are supplied to sense amplifiers through bit lines. The word lines, bit lines, and sense amplifiers are provided in the memory core 25. The column decoder 24 decodes the column address, and activates a column selecting line corresponding to the column specified by the decoded address. The sense amplifiers corresponding to the selectively activated column selecting line are coupled to the data register 28.

The data register 28 supplies the retrieved data to the data input/output interface 26. The data input/output interface 26 supplies the retrieved data to the exterior of the pseudo SRAM 11 at the time of read operation, and receives write data from the exterior at the time of write operation. The data input/output interface 26 supplies the write data to the data register 28 through the write register 27. The write data stored in the data register 28 is then written to the memory cells corresponding to the selected word via the sense amplifiers, bit lines, etc., of the memory core 25.

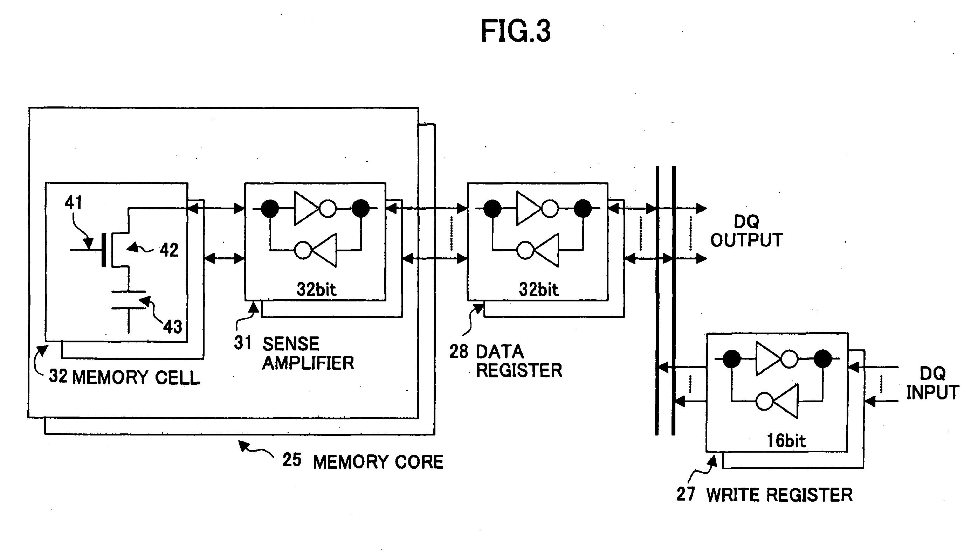

Fig. 3 is a drawing for explaining the relationships between the memory core 25, the write register 27, and the data register 28 of the pseudo SRAM 11.

As shown in Fig. 3, the pseudo SRAM 11 includes the 16-bit write register 27 corresponding to one word, and also includes the 32-bit data register 28 corresponding to two words. Data that the pseudo SRAM 11 exchanges with the system bus 13 (Fig. 1) at a time is 16 bits whereas data that the memory core 25 exchanges with the data register 28 at a time is 32 bits. This 32-bit data is supplied to memory cells 32 via a 32-bit sense amplifier 31 in the case of a write operation, for example. In the memory cells 32, transistors 42 connected to a selectively activated word line 41 are made conductive, so that electric charge responsive to the write data is stored in capacitors 43.

In such a configuration, a single access operation with respect to the memory core 25 is sufficient while data input/output between the pseudo SRAM 11 and the system bus 13 is performed twice. Accordingly, the external data transfer can have a cycle faster than the cycle for the internal core operation. In the example of Fig. 3, the data register 28 is comprised of 32 bits. Alternatively, a 64-bit configuration may be used, so that four words are exchanged with the exterior by taking four cycles each for one word. In the present invention, the number of words in the data register 28 is not limited to a particular number.

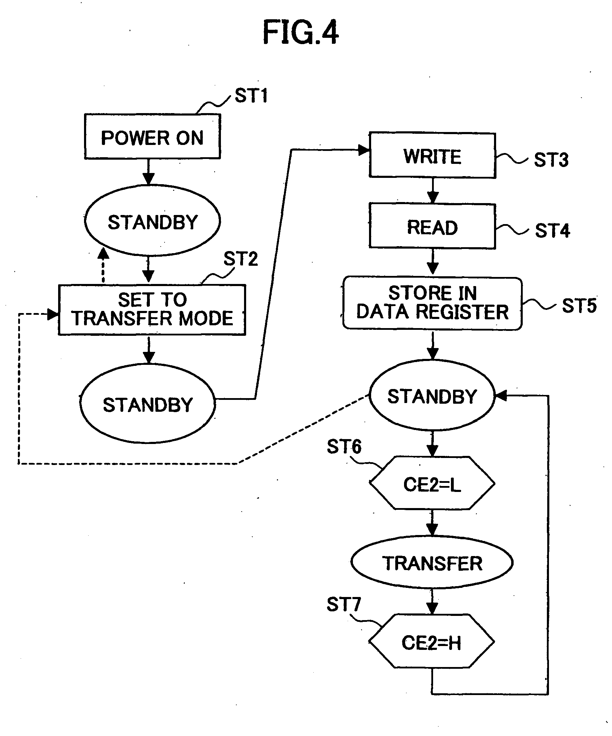

Fig. 4 is a flowchart showing a data transfer operation according to the present invention.

At step ST1 of Fig. 4, power is turned on, resulting in a standby state. At step ST2, the controller 10 asserts a transfer mode signal, thereby setting the pseudo SRAM 11 in a transfer preparation mode. In a normal operation mode other than the transfer preparation mode, the pseudo SRAM 11 is placed in the unselected state in response to a drop to LOW of a chip-enable signal CE2. After being set in the transfer preparation mode, however, the LOW level of the chip-enable signal CE2 initiates an operation of transferring data from the pseudo SRAM 11 to the flash memory 12. After step ST2, the pseudo SRAM 11 is placed in standby state.

At step ST3, the controller 10 writes cache data to the pseudo SRAM 11, and also stores flag information in the write register 27 of the pseudo SRAM 11. At the time of writing this cache data, the controller 10 transfers two words of cache data to the pseudo SRAM 11 by performing one-word transfer twice, so that the two words are stored in the memory core 25. If the data register 28 of the pseudo SRAM 11 is comprised of four words, for example, one-word transfer is performed four times, so that four words are stored in the memory core 25. The flag information noted above serves to store a value (e.g., "0") indicative of the uncompleted status of the data transfer operation in the data register 28.

At step ST4, the controller 10 supplies a read command to the pseudo SRAM 11. At step ST5, the pseudo SRAM 11 performs a read operation, and transfers the data of two words stored in the memory core 25 to the data register 28. Namely, the reading of data from the same address of the pseudo SRAM 11 as the write address provides for the write data written at step ST3 to be stored in the data register 28. In order to hide the time required for writing to the flash memory 12, there is a need to store a large number of data in the data register 28. In consideration of this, one-word write operation is performed multiple times as was described in step ST3, thereby storing the data comprised of multiple words in the data register 28. After step ST5, the standby mode is activated.

Thereafter, at step ST6, the controller 10 supplies to the pseudo SRAM 11 a command for performing data transfer by use of the pseudo SRAM 11 as a temporary area. To be specific, the chip-enable CE2 of the pseudo SRAM 11 is set to LOW. With this, the pseudo SRAM 11 is placed in the transfer processing mode. In the transfer processing mode, the pseudo SRAM 11 does not function as a memory for storing another data, and lapses into an inactive state by suspending even refresh operations. Since the refresh operations are suspended, the current consumption in the pseudo SRAM 11 is extremely low during this time period. With the pseudo SRAM 11 in this state, the controller 10 reads the data from the data register 28 of the pseudo SRAM 11, and supplies a write command to the flash memory 12, thereby transferring the data read from the pseudo SRAM 11 to the flash memory 12 via the system bus 13. When the controller 10 confirms that the transfer of the data from the data register 28 of the pseudo SRAM 11 to the flash memory 12 was successfully completed, the controller 10 rewrites the flag information stored in the write register 27 of the pseudo SRAM 11 such that the new value (e.g., "1") indicates the completion of the data transfer operation. With this, the transfer operation comes to an end.

At step ST7, the controller 10 finishes the mode by which data is transferred by using the pseudo SRAM 11 as a temporary area. To be specific, the chip-enable CE2 of the pseudo SRAM 11 is changed to HIGH. With this, the pseudo SRAM 11 is placed in the standby condition.

In this manner, when the cache data of the controller 10 is transferred to the flash memory 12, the pseudo SRAM 11 is used as a temporary buffer so as to avoid the situation in which the controller 10 is bound for a long time period corresponding to the writing of data to the flash memory 12. Further, the use of the data register 28 of the pseudo SRAM 11 as a temporary buffer and the suspension of the refresh operation to place the memory core 25 in an inactive state make it possible to keep the current consumption in the pseudo SRAM 11 to a minimum during the data transfer period.

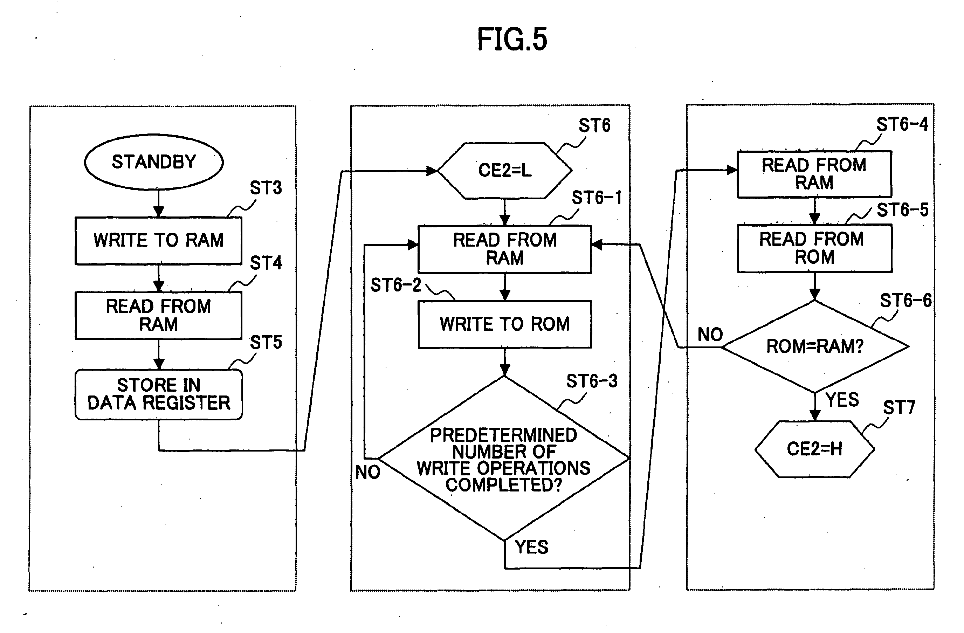

Fig. 5 is a flowchart showing the transfer process described above.

Steps ST3 through ST6 of Fig. 5 are the same as steps ST3 through ST6 of Fig. 4. After step ST6, at step ST6-1, the controller 10 reads one word's worth of data from the data register 28 of the pseudo SRAM 11. At step ST6-2, the controller 10 supplies a write command to the flash memory 12, thereby writing to the flash memory 12 the one word's worth of data read from the pseudo SRAM 11 to the system bus 13.

At step ST6-3, the controller 10 checks whether a predetermined number of write operations with respect to the flash memory 12 have been completed. If the number of words of the transfer data stored in the data register 28 is n, data read operations from the pseudo SRAM 11 and data write operations to the flash memory 12 need to be performed n times in order to complete the predetermined number of write operations with respect to the flash memory 12. If the predetermined number of write operations are not completed, the procedure returns to step ST6-1. When all the words stored in the data register 28 are transferred to the flash memory 12 through the predetermined number of data write operations, the procedure proceeds to step ST6-4.

At step ST6-4, the controller 10 reads the data from the data register 28 of the pseudo SRAM 11. At step ST6-5, the controller 10 reads the corresponding data from the flash memory 12. At step ST6-6, the controller 10 checks whether the data read from these two memories match. To be specific, the read operation and match checking operation described here are successively performed separately for each word. If the data do not match, it is ascertained that the writing is not properly completed, so that the procedure returns to step ST6-1 to perform the write operation again. If the data match, at step ST7, the controller 10 finishes the mode that transfers data by use of the pseudo SRAM 11 as a temporary area. In doing so, the controller 10 rewrites the flag information stored in the write register 27 of the pseudo SRAM 11 such that the new value (e.g., "1") indicates the completion of the data transfer operation. This flag information is used when the power is switched off during the data transfer operation, for example, thereby making it possible to check whether the data transfer was successfully completed after the system operation is resumed.

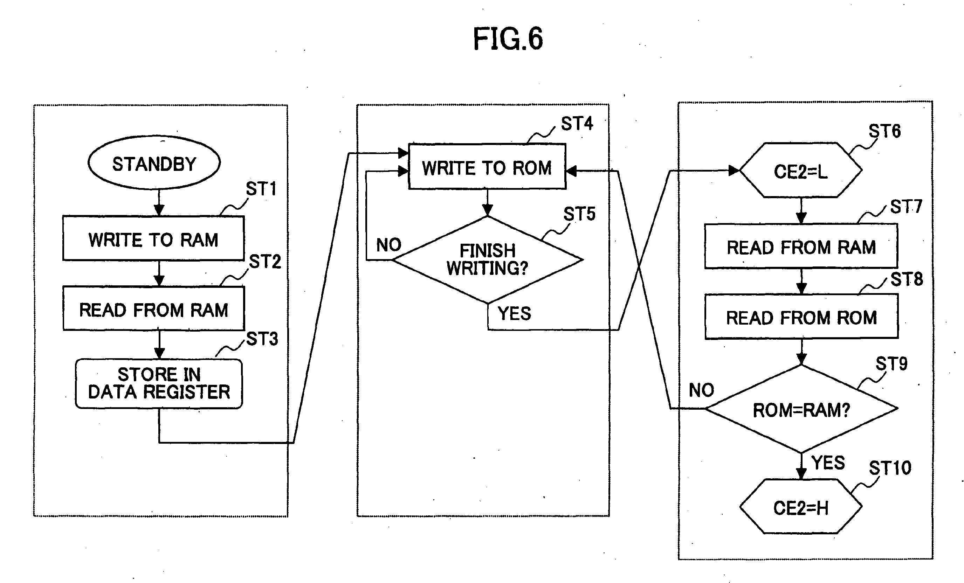

Fig. 6 is a flowchart showing another embodiment of the transfer process according to the present invention.

At step ST1 in Fig. 6, the controller 10 writes cache data to the pseudo SRAM 11, and also stores flag information in the write register 27 of the pseudo SRAM 11. When writing this cache data, the controller 10 transfers the two words worth of cache data to the pseudo SRAM 11 by performing a one-word transfer twice, so that the two words are stored in the memory core 25. Further, the flag information noted above serves to store in the data register 28 a value (e.g., "0") indicative of the uncompleted status of the data transfer operation.

At step ST2, the controller 10 supplies a read command to the pseudo SRAM 11. At step ST3, the pseudo SRAM 11 performs a read operation, thereby transferring the two word data stored in the memory core 25 to the data register 28.

At step ST4, the controller 10 writes the cache data to the flash memory 12. In so doing, the controller 10 does not write the transfer data of the data register 28 of the pseudo SRAM 11 to the flash memory 12, but writes the cache data directly from the controller 10 to the flash memory 12. As the flash memory 12, there is such a type of model that an internal register has a sufficient capacity for storing write data supplied from an exterior. At step ST4, such internal register of the flash memory 12 is utilized so that all the cache data of the controller 10 is first stored in the internal register of the flash memory 12. Thereafter, a write operation is performed inside the flash memory 12 so that the contents of this register are written to the flash memory core.

At step ST5, the controller 10 checks whether the write operation of the flash memory 12 is completed. If completed, the procedure proceeds to step ST6.

At step ST6, the controller 10 changes the chip-enable CE2 of the pseudo SRAM 11 to LOW. In response, the pseudo SRAM 11 enters into a transfer mode. At step ST7, the controller 10 reads the data from the data register 28 of the pseudo SRAM 11. At step ST8, the controller 10 reads the corresponding data from the flash memory 12. At step ST9, the controller 10 checks whether the data read from these two memories match. To be specific, the read operation and match checking operation described here are successively performed separately for each word. If the data do not match, it is ascertained that the writing is not properly completed, so that the procedure returns to step ST4 to perform the operation for writing data from the internal register of the flash memory 12 to the flash memory core. If the data match, at step ST10, the chip-enable signal CE2 is changed to HIGH. In so doing, the controller 10 rewrites the flag information stored in the write register 27 of the pseudo SRAM 11 such that the new value (e.g., "1") indicates the completion of the data transfer operation.

As described above, an internal register having the sufficient capacity to store the write data supplied from the exterior may be provided in the flash memory 12. In such a case, this register may be utilized to perform the data transfer.

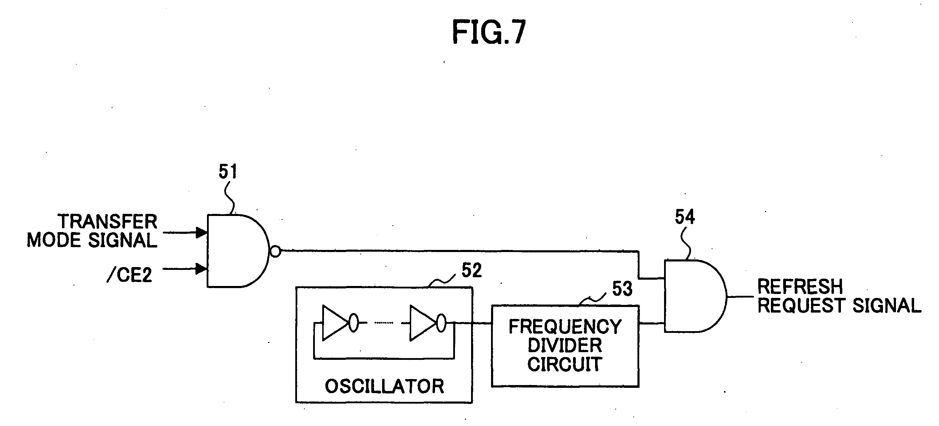

Fig. 7 is a drawing showing an example of the configuration of a refresh request signal generating circuit of the pseudo SRAM 11.

The refresh request signal generating circuit of Fig. 7 includes a NAND gate 51, an oscillator 52, a frequency divider circuit 53, and an AND gate 54. The NAND gate 51 receives a transfer mode signal and an inverse /CE2 of the chip-enable signal CE2 from the controller 10. The transfer mode signal is asserted at step ST2 in the procedure shown in Fig. 4.

With the transfer mode signal being asserted at HIGH, the chip-enable signal CE2 changes to LOW as shown at step ST6 of Fig. 4, resulting in the output of the NAND gate 51 being changed to LOW, thereby closing the gate of the AND gate 54. The oscillator 52 oscillates at predetermined frequency, and the frequency divider circuit 53 divides the frequency of the oscillating signal so as to generate a periodic pulse signal. When the gate of the AND gate 54 is closed, the periodic pulse signal from the frequency divider circuit 53 does not pass through the AND gate 54, thereby not being supplied to a refresh circuit as a refresh request signal. Accordingly, the refresh operation of the pseudo SRAM 11 is suspended.

When the transfer mode signal is not asserted, the output of the NAND gate 51 is HIGH regardless of the level of the chip-enable signal CE2. The refresh request signal thus continues to be supplied to the refresh circuit.

Fig. 8A is a diagram showing a typical configuration of the stepped-down potential generating circuit that generates an internal stepped-down potential Vii in the pseudo SRAM 11.

The stepped-down potential generating circuit shown in Fig. 8A includes an NMOS transistor 61 that receives a predetermined gate voltage V1 applied to its gate. The drain node is coupled to an external power supply voltage Vdd, and the source node supplies the internal stepped-down potential Vii. When the stepped-down potential Vii drops due to the current consumption by the internal circuit, a difference between the gate potential V1 and the source potential (stepped-down potential Vii) widens, resulting in an increase in the current flowing through the NMOS transistor 61. This serves to raise the stepped-down potential Vii. With this provision, the stepped-down potential Vii is controlled to be a constant potential that is determined by the gate potential 1.

Fig. 8B is a diagram showing a change in the stepped-down potential after the pseudo SRAM 11 enters into the transfer mode. As shown in Fig. 8B, when the pseudo SRAM 11 is set in the transfer mode, the stepped-down potential Vii generated by the stepped-down potential generating circuit shown in Fig. 8A gradually rises to approach the external voltage Vdd. This is because the setting of the pseudo SRAM 11 in the transfer mode results in the refresh operation being suspended, so that the consumption of the stepped-down voltage Vii by the internal circuit stops. If the stepped-down potential Vii rises in this manner, an expected error may occur when the pseudo SRAM 11 resumes its normal operation after exiting from the transfer mode.

Fig. 9A is a diagram showing a configuration of the stepped-down potential generating circuit according to the present invention.

The stepped-down potential generating circuit of Fig. 9A includes an NMOS transistor 62 connected in series with the NMOS transistor 61 shown in Fig. 8A, with its gate receiving the output of an AND gate 63. The AND gate 63 receives the transfer mode signal and an inverse /CE2 of the chip-enable signal CE2 from the controller 10. The transfer mode signal is asserted at step ST2 in the procedure shown in Fig. 4.

With the transfer mode signal being asserted at HIGH, the chip-enable signal CE2 changes to LOW as shown at step ST6 of Fig. 4, resulting in the pseudo SRAM 11 entering into the transfer mode. At this time, the output of the AND gate 63 becomes HIGH, so that the NMOS transistor 62 becomes conductive to allow the passage of an electric current, which consumes the current of the stepped-down voltage Vii.

Fig. 9B is a diagram showing a change in the stepped-down potential after the pseudo SRAM 11 enters into the transfer mode. As shown in Fig. 9B, even when the pseudo SRAM 11 is set in the transfer mode, the stepped-down potential Vii stays at a predetermined potential defined by the potential V1 since the current of the stepped-down voltage Vii is consumed as described above. This successfully avoids an unexpected error and the like occurring due to an increase in the stepped-down voltage Vii.

The use of the data transfer method as described above provides for the system configuration to dispose of SRAMs. As a result, the number of memory components can be decreased to achieve cost reduction. Further, the number of memory devices is decreased in the MCP structure containing a plurality of memory devices, thereby contributing to the thinning of the package, which makes the mobile phone device thinner. When a large number of memories are contained in the same package, the layout of interconnect wires inside the package tend to become complex. The present invention suppresses an increase in the complexity of the wire layout, thereby making the manufacturing of the device easier.

## Claims

1. A semiconductor memory device, comprising:
a memory core circuit (25) configured to require a refresh operation for retaining data;
a potential step-down circuit (61, 62, 63) configured to step down an external power supply voltage (V_{DD}) to generate a stepped-down potential power supply (Vᵢᵢ);
a circuit (51-54) configured to suspend the refresh operation in response to a command (TRANSFER MODE SIGNAL) from an exterior;
**characterized in that** the potential step-down circuit comprises a transistor (62) configured to become conductive in response to the command (TRANSFER MODE SIGNAL) for suspending the refresh operation so as to start consuming the stepped-down potential power supply (Vᵢᵢ) upon the suspension of the refresh operation.

2. Semiconductor memory according to claim 1, wherein said transistor (62) is a first NMOS transistor, wherein the potential step-down circuit includes a second NMOS transistor (61), connected in series with said first NMOS transistor (62), with the gate of said first NMOS transistor receiving the output of an AND gate (63) which receives said command (TRANSFER MODE SIGNAL) and an inverse (/CE2) of the chip-enable signal (CE2) from a controller (10).

## Patentansprüche

1. Halbleiterspeichervorrichtung mit:
einer Speicherkernschaltung (25), die konfiguriert ist, um eine Auffrischoperation zum Halten von Daten zu erfordern;
einer Potentialherabstufungsschaltung (61, 62, 63), die konfiguriert ist, um eine externe Energiezufuhrspannung (V_{dd}) herabzustufen, um eine Energiezufuhr (Vᵢᵢ) mit herabgestuftem Potential zu generieren;
einer Schaltung (51-54), die konfiguriert ist, um die Auffrischoperation als Antwort auf einen Befehl (TRANSFERMODUSSIGNAL) von außen zu suspendieren;
**dadurch gekennzeichnet, dass** die Potentialherabstufungsschaltung einen Transistor (62) umfasst, der konfiguriert ist, um als Antwort auf den Befehl (TRANSFERMODUSSIGNAL) zum Suspendieren der Auffrischoperation leitend zu werden, um den Gebrauch der Energiezufuhr (Vᵢᵢ) mit herabgestuftem Potential bei der Suspendierung der Auffrischoperation zu starten.

2. Halbleiterspeicher nach Anspruch 1, bei der der Transistor (62) ein erster NMOS-Transistor ist, wobei die Potentialherabstufungsschaltung einen zweiten NMOS-Transistor (61) enthält, der mit dem ersten NMOS-Transistor (62) seriell verbunden ist, wobei das Gate des ersten NMOS-Transistors die Ausgabe eines UND-Gatters (63) empfängt, das den Befehl (TRANSFERMODUSSIGNAL) und eine Inversion (/CE2) des Chipfreigabesignals (CE2) von einem Controller (10) empfängt.

## Revendications

1. Dispositif de mémoire à semiconducteur, comprenant :
un circuit de noyau de mémoire (25) qui est configuré de manière à nécessiter une opération de rafraîchissement pour retenir des données ;
un circuit abaisseur de potentiel (61, 62, 63) qui est configuré pour abaisser une tension d'alimentation externe (V_{DD}) pour générer une alimentation en potentiel abaissée (Vii) ;
un circuit (51-54) qui est configuré pour suspendre l'opération de rafraîchissement en réponse à une commande (SIGNAL DE MODE TRANSFERT) en provenance de l'extérieur,
**caractérisé en ce que** le circuit abaisseur de potentiel comprend :
un transistor (62) qui est configuré pour devenir conducteur en réponse à la commande (SIGNAL DE MODE TRANSFERT) pour suspendre l'opération de rafraîchissement de manière à démarrer la consommation de l'alimentation en potentiel abaissée (Vii) suite à la suspension de l'opération de rafraîchissement.

2. Mémoire à semiconducteur selon la revendication 1, dans laquelle ledit transistor (62) est un premier transistor NMOS, le circuit abaisseur de potentiel inclut un second transistor NMOS (61) connecté en série avec ledit premier transistor NMOS (62), la grille dudit premier transistor NMOS recevant la sortie d'une porte ET (63) qui reçoit ladite commande (SIGNAL DE MODE TRANSFERT) et un inverse (/CE2) du signal de validation de puce (CE2) en provenance d'un contrôleur (10).
